# EUROPÄISCHE PATENTSCHRIFT

(11) **EP 0 758 080 B1**
(45) Veröffentlichungstag und Bekanntmachung des Hinweises auf die Patenterteilung: **30.09.1998**
(21) Anmeldenummer: 96111549.0
(22) Anmeldetag: 17.07.1996
(51) Int. Cl.: G01L 9/00, H01L 23/00

(54) **Mikromechanisches Bauelement mit perforierter, spannungsfreier Membran**
Micromechanical device with stress-free perforated diaphragm
Dispositif micromécanique avec un diaphragme perforé sans contraintes

(30) Priorität: 09.08.1995 DE 19529335
(43) Veröffentlichungstag der Anmeldung: 12.02.1997
(73) Patentinhaber: SIEMENS AKTIENGESELLSCHAFT, 80333 München (DE)
(72) Erfinder: Catanescu, Ralf, 28201 Bremen (DE); Näher, Ulrich, Dr., 80803 München (DE); Scheiter, Thomas, 80469 München (DE); Hierold, Christofer, Dr., 81739 München (DE)

(56) Entgegenhaltungen:
- EP-A- 0 349 001
- EP-A- 0 474 280
- EP-A- 0 663 692
- DE-A- 3 445 774
- JP-A-61 285 772
- US-A- 4 776 019
- US-A- 5 059 556

## Beschreibung

Die vorliegende Erfindung betrifft mikromechanische Bauelemente, wie z. B. Sensoren oder Aktuatoren, bei denen eine dünne Membran z. B. für eine Druckmessung vorhanden ist.

Zur Druckmessung können Drucksensoren eingesetzt werden, die in Oberflächen-Mikromechanik hergestellt sind. Der prinzipielle Aufbau solcher Bauelemente besteht aus einer geschlossenen Kammer, in der ein Bezugsdruck herrscht und die durch eine elastische Membran nach außen abgeschlossen ist. Die Verformung dieser Membran durch den von außen einwirkenden Druck kann als Maß für die Größe dieses Druckes ausgewertet werden.

Derartige Membranen, die z. B. durch dünne Schichten aus Polysilizium gebildet werden, werden auch bei anderen mikromechanischen Sensoren, z. B. bei Beschleunigungssensoren als Masseteil, verwendet. Ein entscheidendes Problem bei der Herstellung derartiger Membranen ist der in der für die Membran vorgesehenen Schicht auftretende Stress (mechanische Spannung). In der Regel werden abgeschiedene Schichten (z. B. aus Polysilizium) als Material für Schichten, die für die Funktion des Bauelementes vorgesehen sind, also z. B. eine Membran verwendet. Je nach Herstellungsprozeß weisen diese Schichten einen Zugstress oder einen Druckstress auf. Besonders bei der Herstellung von Drucksensoren führt das zu Schwierigkeiten bei der Verwendung des Bauelements. Ein solcher Schichtstress führt zur Veränderung der Steifigkeit und zur Verwölbung der Membran und damit zu einer Änderung der Empfindlichkeit des Sensors. Druckstress kann außerdem Ursache für eine auftretende Hysterese sein. Es ist daher notwendig, die Membranen ohne mechanische Spannung oder zumindest mit einer ausreichend geringen mechanischen Spannung herzustellen.

Bisher versuchte man, den Schichtstress durch nach dem Aufbringen der Schicht durchgeführte Prozeßschritte, in der Regel Temperungen, zu reduzieren. Problematisch ist dabei, daß die erforderlichen Temperaturen unter Umständen vorhandene Teile des Bauelementes beschädigen oder beeinträchtigen. Bei der monolithischen Integration mit Bauelementen elektronischer Schaltungen ergeben sich durch diese mangelnde Kompatibilität der Temperungen wesentliche Probleme und Einschränkungen. Außerdem ist es mit bisherigen Methoden nicht möglich, den Grad an Freiheit von mechanischer Spannung vordefiniert einzustellen.

In der US 4,776,019 ist eine Membran für ein Kondensatormikrofon angegeben, die in einem dünnen metallischen Film ausgebildet ist, der so ausgeschnitten ist, daß ein als Membran vorgesehener quadratischer innerer Anteil an den Ecken über je einen schmalen Streifen mit einem als Rahmen und Halterung vorgesehenen äußeren Anteil verbunden ist. Diese Ausgestaltung soll die Zugspannung in der Membran vermindern.

Aufgabe der vorliegenden Erfindung ist es, ein mikromechanisches Bauelement anzugeben, bei dem eine für die Funktion vorgesehene Membran ganz oder weitestgehend frei von mechanischer Spannung ist, ohne daß zusätzliche Herstellungsschritte erforderlich sind.

Diese Aufgabe wird mit dem Bauelement mit den Merkmalen des Anspruches 1 gelöst. Weitere Ausgestaltungen ergeben sich aus den abhängigen Ansprüchen.

Erfindungsgemäß wird das Bauelement mit einer Membran versehen, in der rechteckige oder längliche Öffnungen überall vorhanden sind, die mit ihrer Längsrichtung entlang von geraden oder gekrümmten Linien angeordnet sind. Diese Öffnungen sind langgestreckt, wobei die Länge mindestens das Doppelte der Breite der Öffnung ausmacht. Um den Stress zu reduzieren, kann es genügen, derartige Öffnungen ringsum am Rand der Membran vorzusehen. Damit an jeder Stelle des Randes zwischen dem inneren Anteil der Membran und der Befestigung der Membran die Schicht durch eine Öffnung unterbrochen ist, können die in der Membran vorgesehenen Öffnungen z. B. längs zweier parallel zueinander verlaufender Linien angeordnet sein. Die Membran wird vorzugsweise durch einen beweglichen Anteil einer Membranschicht gebildet. Die äußeren Anteile der Membranschicht sind auf einem Substrat oder einer Halbleiter schichtstruktur aufgebracht. Die Membran wird durch den inneren, nicht befestigten Anteil dieser Membranschicht gebildet und kann z. B. bei einem Drucksensor senkrecht zur Schichtebene schwingen. Bei einem Beschleunigungssensor kann die Membran, die ein zur Bestimmung einer Trägheitskraft vorgesehenes Masseteil bildet, z. B. an federnden Verstrebungen mit dem äußeren Anteil der Membranschicht verbunden sein, so daß die Membran sich auch in der Schichtebene hin und her bewegen kann. Das Problem des Stress tritt vorwiegend bei einer ringsum befestigten Membran auf. Daher sind die Öffnungen in der Membran vorzugsweise in der Nähe des Randes des als Membran vorgesehen Anteils der Membranschicht angeordnet. Wenn die Membran sehr groß ist, sind vorzugsweise weitere Öffnungen im Innern der Membran z. B. längs gerader, von Rand zu Rand der Membran verlaufender Linien vorhanden. Wenn die Membran für einen Drucksensor vorgesehen ist, so daß die von der Membran begrenzte Kammer nach außen luftdicht abgeschlossen sein muß, werden die vorhandenen Öffnungen z. B. mit einer auf die Membranschicht aufgebrachten Verschlußschicht verschlossen. Es genügt, wenn diese Verschlußschicht im Bereich der vorgesehenen Öffnungen aufgebracht wird, so daß z. B. vermieden werden kann, die Steifigkeit der Membran im Innern durch eine zusätzliche Schicht über das gewollte Maß hinaus zu erhöhen.

Es folgt eine genauere Beschreibung des erfindungsgemäßen Bauelementes anhand der Figuren 1 bis 4.
- Figuren 1 und 2: zeigen Ausführungsbeispiele der Membran des Bauelementes in Aufsicht.
- Figuren 3 und 4: zeigen im Schema typische Anordnungen und Ausrichtungen der Membranöffnungen.

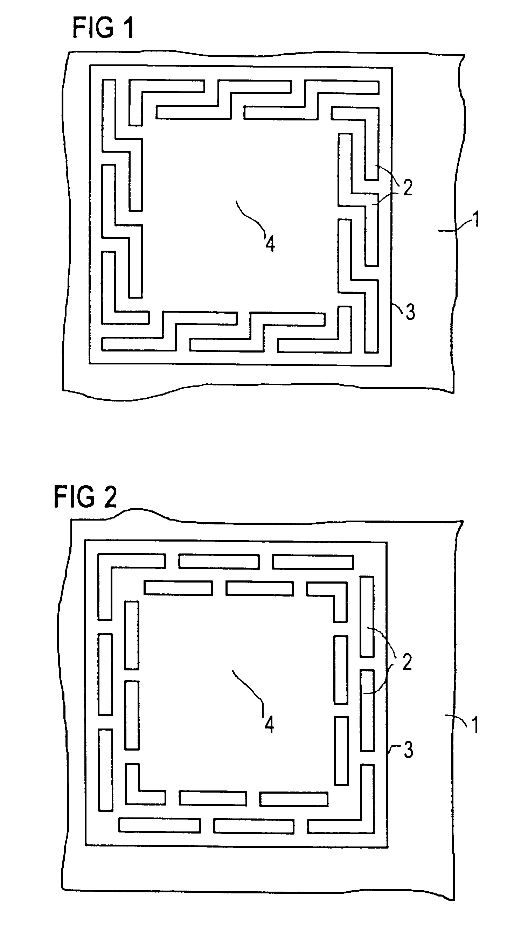

In Figur 1 ist als Beispiel eine Membranschicht 1 im Ausschnitt in Draufsicht gezeichnet. Am Rand 3 des für die Membran 4 vorgesehenen Anteils dieser Membranschicht 1 sind Öffnungen 2 vorhanden. Die Öffnungen 2 sind bei diesem Beispiel jeweils durch mehrere rechteckige Öffnungen gebildet, die mit ihren Enden im rechten Winkel zueinander aneinandergesetzt sind. Die Öffnungen sind mit ihrer Längsrichtung entlang dem Rand 3 so ausgerichtet, daß an jeder Stelle des Randes in der Richtung senkrecht zum Rand zum Innern der Membran 4 hin die Membranschicht 1 durch mindestens eine Öffnung unterbrochen ist.

In Figur 2 ist ein weiteres Beispiel in einem der Figur 1 entsprechenden Ausschnitt dargestellt. In der Membranschicht 1 befinden sich Öffnungen 2 längs des Randes 3 eines für die Membran 4 vorgesehenen Anteiles. Die Mehrzahl der Öffnungen 2 bei diesem Ausführungsbeispiel ist rechteckig. Die Öffnungen sind längs einer parallel zum Rand verlaufenden Linie in zwei Reihen parallel nebeneinander ausgerichtet. Die Verminderung der mechanischen Spannung in der Membran 4 erfolgt auch bei diesem Beispiel vorwiegend in den Richtungen senkrecht zum Rand 3. Die Abstände je zweier zueinander benachbarter Öffnungen wird dabei vorzugsweise so gering gewählt, daß er kleiner ist als die Länge einer dieser Öffnungen. Trotz der nur sehr schmalen Verbindungen zwischen der Membran 4 und dem befestigten Anteil der Membranschicht 1 kann bei einer großen Zahl vorgesehener Öffnungen 2 und damit einer großen Anzahl von Verbindungen auch eine ausreichende mechanische Stabilität bei gleichzeitigem Abbau der mechanischen Spannung erreicht werden.

Der Einfachheit halber sind in den Figuren 1 und 2 Öffnungen nur am Rand 3 der Membran 4 eingezeichnet. Grundsätzlich können solche Öffnungen auch im Innern der Membran vorhanden sein. Insbesondere bei großflächigen Membranen kann es für einen vollständigen Abbau des Stress erforderlich sein, auch im Innern der Membran Öffnungen vorzusehen. Auch dort werden rechteckige oder längliche Öffnungen mit ihrer Längsrichtung entlang von Linien ausgerichtet. Diese Linien können geschlossen sein und in konstantem Abstand vom Rand 3 der Membran 4 verlaufen. Die Linien können statt dessen von einem Punkt des Randes 3 zu einem gegenüberliegenden Punkt durch das Innere der Membran verlaufen. Diese Linien sind vorzugsweise gerade. Auch bei diesen weiteren Anordnungen von Öffnungen im Innern der Membran werden die Öffnungen vorzugsweise entlang der Linien in zwei zueinander parallelen Reihen nebeneinander so angeordnet, daß senkrecht zu der betreffenden Linie die Membran an jeder Stelle durch mindestens eine Öffnung unterbrochen ist. Die Anordnung der Öffnungen längs einer Linie kann zwischendurch unterbrochen sein. Das Aufbringen einer Verschlußschicht auf die Membranschicht wird durch eine ausreichend geringe Breite der Öffnungen ermöglicht.

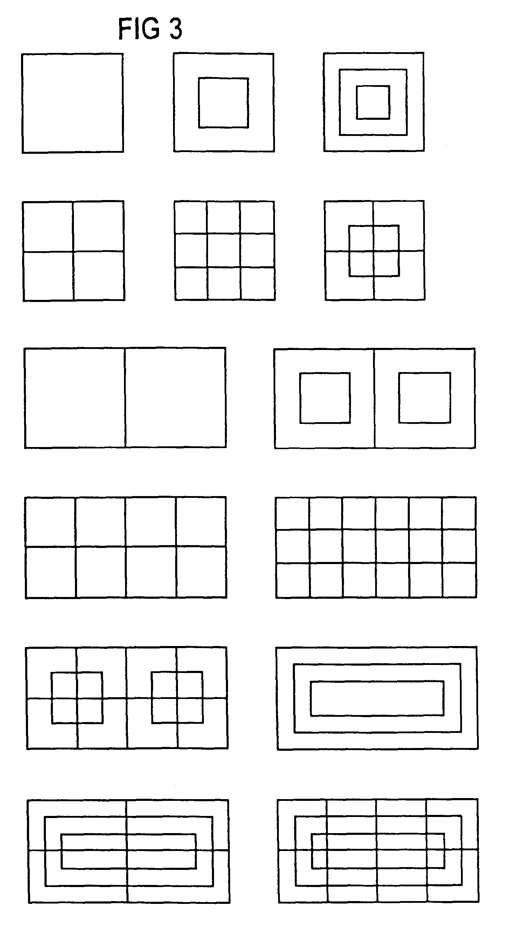

In der Figur 3 sind im Schema Linien eingezeichnet, längs derer bei einer quadratischen oder rechteckigen Membran vorzugsweise die erfindungsgemäß vorgesehenen Öffnungen angeordnet sind. Bei einer quadratischen Membran kann es genügen, wenn entsprechend den Beispielen der Figuren 1 und 2 Öffnungen nur längs des Randes vorhanden sind (s. Beispiel links oben in Figur 3). Bei größeren Membranen kann es vorteilhaft sein, entlang Linien, die in größerem konstantem Abstand zum Rand der Membran verlaufen, ebenfalls Öffnungen vorzusehen. Beispiele dafür sind in der ersten Zeile in Figur 3 angegeben. Bei dem rechten Beispiel sind insgesamt drei quadratische Linien vorhanden, entlang derer längliche oder rechtekkige Öffnungen entsprechend z. B. den Beispielen der Figur 1 und 2 vorhanden sind. In der zweiten Zeile der Figur 3 sind Beispiele dafür angegeben, daß Öffnungen zusätzlich entlang geraden Linien im Innern der Membran vorhanden sein können. Entsprechend der Größe der Membran kann es genügen, wenn in zwei senkrecht zueinander verlaufenden Richtungen die Membran jeweils durch eine Reihe von erfindungsgemäßen Öffnungen unterteilt wird (linkes Beispiel in der zweiten Zeile von Figur 3). Die Öffnungen können aber auch entsprechend den weiteren Beispielen dieser zweiten Zeile von Figur 3 entlang mehrerer parallel zueinander oder zum Rand verlaufender Linien vorhanden sein. Die weiteren in Figur 3 dargestellten Beispiele betreffen rechteckige Membranen, die der Einfachheit halber jeweils doppelt so lang wie breit gezeichnet sind. Die eingezeichneten Linien unterteilen diese Membran jeweils in mehrere Teile, die so klein sind, daß kein nennenswerter Schichtstress in diesen Bereichen auftritt. Öffnungen sind auch hier vorzugsweise überall längs der eingezeichneten Linien vorhanden. Die Reihen der Öffnungen können aber auch zwischendurch unterbrochen sein. Die gezeichneten Beispiele sind entsprechend den Abmessungen der Membran nach Bedarf so variierbar, daß jeweils der mechanische Stress in der Membran in vorgesehenem Ausmaß reduziert ist.

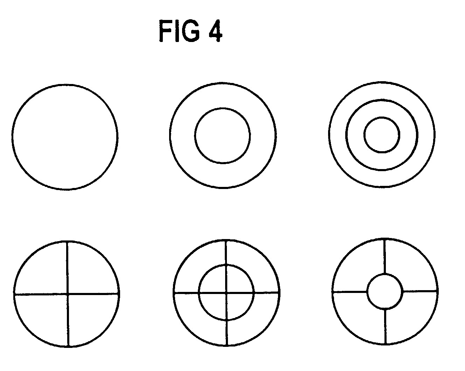

Figur 4 gibt entsprechende Beispiele für runde Membranen an. Bei dem Beispiel links oben sind die Öffnungen längs des kreisförmigen Randes der Membran vorhanden. Die Öffnungen können auch hier längs konzentrischer Kreise im Innern der Membran angeordnet sein. Die Form der Öffnungen ist dann vorzugsweise gekrümmt und besitzt den Krümmungsradius der betreffenden Linie. In den Beispielen in der zweiten Zeile von Figur 4 sind zusätzliche Öffnungen längs gerader Linien angeordnet. Die längs der geraden Linien angeordneten Reihen von Öffnungen sind in dem rechten Beispiel in der Mitte unterbrochen, wo Öffnungen längs eines kleinen Kreises im Innern der Membran, der konzentrisch zum Rand der Membran ausgerichtet ist, angeordnet sind.

## Patentansprüche

1. Mikromechanisches Bauelement mit einer für einen Sensor/Aktuator vorgesehenen Membranschicht (1),
bei dem in dieser Membranschicht (1) entlang mindestens einer geschlossenen oder von Rand zu Rand verlaufenden Linie Öffnungen (2) vorhanden und so angeordnet sind, daß überall längs dieser Linie die Membranschicht in der Richtung senkrecht zu dieser Linie durch eine dieser Öffnungen unterbrochen ist,
bei dem diese Öffnungen rechteckig oder länglich sind,
bei dem die Länge dieser Öffnungen mindestens doppelt so groß ist wie die Breite dieser Öffnungen und
bei dem diese Öffnungen mit ihrer Längsrichtung längs der mindestens einen Linie ausgerichtet sind.

2. Bauelement nach Anspruch 1,
bei dem solche Öffnungen entlang einer Linie angeordnet sind, die in konstantem Abstand zu einem Rand (3) eines als Membran (4) vorgesehenen Anteils der Membranschicht (1) verläuft.

3. Bauelement nach Anspruch 1 oder 2,
bei dem solche Öffnungen entlang einer geraden Linie angeordnet sind, die von Rand (3) zu Rand (3) eines als Membran (4) vorgesehenen Anteils der Membranschicht (1) und im Innern der Membran (4) verläuft.

4. Bauelement nach einem der Ansprüche 1 bis 3,
bei dem die Öffnungen durch eine zumindest im Bereich dieser Öffnungen auf der Membranschicht aufgebrachte Verschlußschicht verschlossen sind.

## Claims

1. Micromechanical device with a diaphragm layer (1) provided for a sensor/actuator,
in which openings (2) are present in this diaphragm layer (1) along at least one line which is closed or runs from edge to edge, and are arranged in such a way that at every point along this line the diaphragm layer is interrupted by one of these openings in the direction perpendicular to the said line,
in which these openings are rectangular or elongate,
in which the length of these openings is at least twice as large at the width of these openings, and
in which these openings are aligned with their longitudinal direction along the at least one line.

2. Device according to Claim 1,
in which such openings are arranged along a line which runs at a constant distance from an edge (3) of a portion of the diaphragm layer (1) which is provided as the diaphragm (4).

3. Device according to Claim 1 or 2,
in which such openings are arranged along a straight line which runs from edge (3) to edge (3) of a portion of the diaphragm layer (1) which is provided as the diaphragm (4) and inside the diaphragm (4).

4. Device according to one of Claims 1 to 3,
in which the openings are closed off by a closure layer applied to the diaphragm layer at least in the region of the said openings.

## Revendications

1. Dispositif micro mécanique avec une couche de membrane (1) prévue pour un capteur / actuateur,
pour lequel des ouvertures (2) sont présentes dans cette couche de membrane (1), le long d'au moins une ligne fermée ou courant de bord à bord et sont disposées de telle façon que partout le long de cette ligne, dans la direction perpendiculaire à cette ligne, la couche de la membrane est interrompue par l'une de ces ouvertures,
pour lequel ces ouvertures sont rectangulaires ou allongées,
pour lequel la longueur de ces ouvertures est au moins deux fois plus grande que la largeur de ces ouvertures et
pour lequel ces ouvertures sont avec leur direction longitudinale orientées le long d'au moins une ligne.

2. Dispositif selon la revendication 1,
pour lequel de telles ouvertures sont disposées le long d'une ligne qui coure à une distance constante d'un bord (3) d'une partie de la couche de la membrane (1) prévue comme membrane (4).

3. Dispositif selon la revendication 1 ou 2,
pour lequel de telles ouvertures sont disposées le long d'une ligne droite qui coure de bord (3) à bord (3) d'une partie de la couche de la membrane (1) prévue comme membrane (4) et à l'intérieur de la membrane (4).

4. Dispositif selon l'une des revendications 1 à 3,
pour lequel les ouvertures sont fermées par une couche de fermeture déposée sur la couche de la membrane au moins dans le domaine de ces ouvertures.
